# EUROPÄISCHE PATENTSCHRIFT

(11) **EP 0 961 379 B1**
(45) Veröffentlichungstag und Bekanntmachung des Hinweises auf die Patenterteilung: **11.12.2002**
(21) Anmeldenummer: 99110278.1
(22) Anmeldetag: 27.05.1999
(51) Int. Cl.: H02H 3/08

(54) **Schaltungsanordnung mit kennfeldorientierter Überlastbewertung**
Circuit arrangement with look-up table oriented overload evaluation
Dispositif de circuit avec évaluation de surcharge orientée sur un tableau de consultation

(30) Priorität: 29.05.1998 DE 19824064
(43) Veröffentlichungstag der Anmeldung: 01.12.1999
(73) Patentinhaber: SEMIKRON Elektronik GmbH, 90431 Nürnberg (DE)
(72) Erfinder: Schimanek, Ernst, 90489 Nürnberg (DE); Billmann, Markus, 90480 Nürnberg (DE)

(56) Entgegenhaltungen:
- JP-A- 7 255 166
- On-Line Monitoring of the ChipTemperature in IGBT Inverters for Propulsion Systems

## Beschreibung

Die Erfindung beschreibt eine Schaltungsanordnung für Stromumrichter nach den Merkmalen des Oberbegriffes des Anspruches 1. Derartige Schaltungsanordnungen sind beispielhaft bekannt aus M. Faschin "On-Line Monitoring of Chip Temperature in IGBT Inverters for Propulsion Systems" in EPE Journal Vol. 5 No. 1 March 1995. Die Problematik der zuverlässigen und zerstörungsfreien Arbeit der Schaltungsanordnungen gewinnt bei der weiteren Erhöhung ihrer Leistungsdichte zunehmend an Bedeutung.

Bei Einsatz von Transistorschaltern aus neuester Entwicklung, wie sie in der Technologie von IGBT und MOSFET dargestellt werden und dem Einsatz von modernen Freilaufdioden mit soft- recovery- Verhalten nach Technologien, wie sie in DE 44 21 529 A1 vorgestellt wurden, können die verschiedensten konventionellen Fehler zur Beeinflussung der Ansteuerung und damit zu Fehlsteuerungen führen, was seinerseits zum Ausfall der Schaltungsanordnung führen kann, oder schwerwiegende negative Folgen in der Arbeitsweise nach sich zieht.

Bei hoher Packungsdichte, also sehr kompaktem Aufbau beeinflußt das Magnetfeld der Hauptstromführungen bei eng benachbarten Hauptstrom- und Ansteuerverbindungen die Funktionssicherheit, insbesondere bei Leistungsschaltern mit hoher Schaltgeschwindigkeit und großen Werten von ^{di}/_{dt} (schnelle Schalter), weil sich jede einzelne Leitungsverbindung als Störimpuls beim Schaltbetrieb verhalten kann, was in der Ansteuerung besonders kritisch ist und deshalb besondere Schutzmaßnahmen erfordert, wie das bereits in DE 196 28 131 A1 dargestellt wurde.

Zumindest wird die mögliche Höchstleistung von Schaltungsanordnungen dadurch gemindert, daß nicht alle Faktoren möglicher Störungen der bei dem Betrieb von Schaltungsanordnungen auftretenden Schwankungen einzelner Parameter konstruktiv so berücksichtigt werden können, wie sie bei dem praktischen Betrieb auftreten können. Es sind für real mögliche negative Parameteränderungen Reserven der Belastbarkeit konstruktiv in der Anordnung einzubauen, die objektiv nicht sinnvoll sind, aber die die Verlustleistungen negativ beeinflussen.

Die Spannweite aller möglichen Störungen ist sehr groß, hier möge nur ein Teil der beeinflussenden Kenngrößen aufgezählt werden, um die Komplexität dieser Erfindung darzustellen:
- Die Betriebssicherheit der Leistungsschalter selbst wird durch seine dynamischen Parameter, deren kenndatenbedingten Schwankungsbreite und des dadurch verursachten unterschiedlichen Temperaturverhaltens bestimmt.
- Die zur Kommutierung eingesetzte Freilaufdiode stimmt nicht völlig in ihrem Verhalten mit dem Leistungsschalter überein.
- Die DCB- Keramik als direkter Träger der eben genannten aktiven mit pn- Übergängen versehenen Leistungsbauelemente besitzt nicht genau die gleiche Geometrie in der Wiederholung bei Parallelschaltungen in einer Schaltungsanordnung.
- Es sind unterschiedlich große Kupferflächen durch das Strukturbild und der Toleranzen in der Ätztechnik für Kupfer vorhanden, dadurch bedingt sind unterschiedliche Kapazitätswerte begründet, die in unterschiedlichem Maße parasitäre Induktivitäten darstellen.

Ein induktivitätsarmer Aufbau wird bereits in der kleinsten Zelle angestrebt, Unterschiede sind praktisch immer vorhanden. Diese Problematik ist beispielhaft Gegenstand der Erfindung in DE 41 05 155 A1.

Wie Erprobungen gezeigt haben, sind wesentliche Gesichtspunkte zur Reduzierung von parasitären Induktivitäten auch in der äußeren Verschaltung der Schaltungsanordnung beachtlich. Möglichkeiten zur Verringerung solcher Induktivität ergeben sich erfindungsgemäß nach DE 42 40 501 A1 dadurch, daß der positive und der negative Stromanschluß für die Schaltungsanordnung nicht nur eng beieinander liegen, sondern aus mehreren Teilanschlüssen gebildet werden, die ihrerseits möglichst symmetrisch an die einzelnen Schalter heranzuführen sind.

Die Streuinduktivität bei Parallel- und Zusammenschaltung mehrerer Kommutierungskreise gewinnt zunehmend an Bedeutung. Bei Parallelschaltungen treten weiterhin unterschiedliche Weglängen der Gleichstrom führenden Stromzweige auf, was zu nicht gewollten veränderten Ansteuerungen der Leistungsschalter führt. Dieser Problematik widmet sich DE 19519538 A1.

Ein weiteres Feld der Toleranzen mit möglichen negativen Wirkungen eröffnet sich bei der Betrachtung der eingesetzten Kühlsysteme. Nicht jede zu kühlende DCB- Keramik kann an einem gleichbegünstigten Ort von einem Kühlkörper auf immer gleicher Temperatur gehalten werden. Die Kühlleistungen an sich sind darüber hinaus in jedem Falle dynamisch zu sehen, denn die abzuführende Verlustleistung kann in Größenordnungen an einzelnen Stellen der DCB- Keramik unterschiedlich sein. Sich verändernde Wärmegradienten des Kühlkörpers können sich darüber hinaus neben all den sich durch äußere Einflüsse ergebenden Faktoren erst im Verlaufe des Betreibens von Schaltungsanordnungen einstellen.

Unterschiedliche Taktfrequenzen, Phasenverschiebungen zwischen aktiver Leistung und Scheinleistung, die Grundfrequenz des Schaltungsausganges und die Zwischenkreisspannungen sind weitere qualitativ genannte Parameter, die zu einer nicht zu überschauenden Vielzahl von Einflußfaktoren gehören, von deren Größe Auswirkungen auf die Funktionssicherheit und Belastbarkeit einer jeden Schaltungsanordnung zu erwarten sind. Nicht alle diese Parameter können konstruktiv so berücksichtigt werden, daß mit einer minimierten Schaltungsreserve ein Konzept verwirklicht werden kann, es sind immer Leistungsabstriche in der Konstruktion von Schaltungsanordnungen zu machen.

Zum Schutz der Schaltungsanordnungen vor negativ auf die Funktionsfähigkeiten wirkender Überlastungen sind neben der Absenkung der vorgeschriebenen maximalen Leistungsfähigkeit Veröffentlichungen bekannt, die Methoden der Früherkennung zerstörerisch wirkender Effekte aufzeigen. Dazu werden die folgenden Erfindungen genannt:

In DE 43 19 254 A1 wird eine Leistungshalbleiterschaltungsanordnung vorgestellt, die zum Schutz vor Überströmen, also auch vor Kurzschlußströmen, vorgesehen wird. Der Überstrom wird hier mittels Stromsensoren erfaßt, die über Fensterkomperatoren, Fehlerspeicher und Einschaltsperren die Schaltungsanordnung durch Abschalten vor Zerstörung schützt.

DE 44 10 978 A1 beschreibt ein Verfahren und eine dazugehörige Schaltung zur Verbesserung der Kurzschlußfestigkeit eines bipolaren MOS- Transistors. Die in dieser Schaltungsanordnung zur Realisierung der Gate- Spannungsfestigkeit eingesetzten Zenerdioden begrenzen die Spannung zwischen dem MOSFET und der Gate- Elektrode des IGBT.

Der Problematik des Kurzschlusses in Stromrichtern mit IGBT oder MOSFET ist in der Literatur nach dem Stand der Technik viel Platz eingeräumt. EP 0 190 925 A1 stellt diese Problematik vor, hier wird die maximal zulässige Durchlaßspannung (Vce) eines IGBT unter Voraussetzung eines maximal erlaubten Kollektorstromes von der Höhe der Gatespannung Vge in Abhängigkeit gebracht, also eine Begrenzung der höchstmöglichen Leistung diktiert.

Die dem Stand der Technik zuordenbaren Maßnahmen zur Erhöhung der Leistungsdichte in den Schaltungsanordnungen beinhalten Maßnahmen zur Verwendung geeigneter paralleler Kupferplatten als Stromschienen, Minimieren der stromdurchflossenen Flächen, Minimieren der Isolationsschichtdicke bei eng benachbarten Platten der gegensätzlichen Pole, Parallelschalten von parasitären Induktivitäten und Zusammenfassen der gleichpoligen Schienen über kurze Wege bei großem Leitungsquerschnitt.

In jüngerer Zeit wird der Einsatz von Sensoren zur Erfassung und Bewertung verschiedener Parameter der Umrichteranordnungen im Echtzeitverhalten beschrieben. Strom- und Temperatursensoren sind zwischenzeitlich fester Bestandteil des Aufbaus von Schaltungsanordnungen der Leistungsklasse, insbesondere zum Erzielen hoher Zuverlässigkeit. Die Augenblickssignale werden mit Schwellwerten verglichen, bei dessen Überschreitung wird das gesamte System abgeschaltet und damit vor Zerstörung bewahrt.

Die Festlegung der Schwellwertgrenzen erfolgt nach dem Stand der Technik in der Konzeptphase der Entwicklung der Schaltungsanordnung, es ist ein festgeschriebener Wert, der statisch aufgeprägt ist. Bei Veränderungen des Systems in einem Teilbereich, wie beispielhaft bei Einsatz eines anderen Kühlkörpers, muß der Schwellwert separat neu festgestellt und eingeprägt werden. Nicht alle Veränderungen von Teilbereichen einer Schaltungsanordnung können prophylaktisch bewertet werden, wodurch die Gefahr für ein unkontrolliertes partielles Übersteigen zulässiger Arbeitsbereiche möglich und auf längere Sicht unvermeidlich ist.

Die vorliegende Erfindung hat die Aufgabe, eine Schaltungsanordnung mit einer Erfassung aller aktuell relevanten Betriebsbedingungen als Parameter vorzustellen, die aus diesen permanent vorhandenen Werten eine selbstadaptierende Stromabschaltschwelle generiert, die unabhängig vom überlagerten Regelsystem arbeitet, so daß eine dynamische Echtzeitbewertung des Leistungsparameter- Kennfeldes erfolgt und somit ausschließlich aktuell normierte Daten über die Auslastung und Belastbarkeit in Form einer kennfeldorientierten Überlastbewertung an das überlagerte Regelsystem des Controllers geliefert werden.

Die Aufgabe wird bei Schaltungsanordnungen der dargestellten Art durch die Maßnahmen des kennzeichnenden Teiles des Anspruches 1 gelöst, bevorzugte Weiterbildungen werden in den Unteransprüchen aufgezeigt.

Das Generieren einer sich selbst adaptierenden Stromabschaltschwelle setzt einerseits das Erfassen und Uniformieren aller signifikanten Parameter aus dem Leistungsteil einer Schaltungsanordnung über Sensoren bzw. elektrische Abzweigungen und andererseits deren Verarbeitung und Bewertung in einer extra zu diesem Zweck eingebauten Ansteuer- und Schutzschaltung voraus.

Erfindungsgemäß wird innerhalb des Leistungsteiles der Schaltungsanordnung aus den Parametern ein mehrdimensionales Kennfeld gebildet, in dem deren Bewertung auf der Grundlage ihrer Auswirkungen auf die Temperaturerhöhung des Gesamtsystems der Schaltungsanordnung erfolgt.

Bedingt durch die hier dargestellten Prämissen ist es sehr vorteilhaft, die erfinderische Schutzschaltung direkt auf dem Leistungsteil der Anordnung zu positionieren, das hat den weiteren Vorteil, daß die Weiterleitung der autark erfaßten Umgebungsbedingungen der zu schützenden Leistungsschalter nicht nur zur Bildung eines dynamischen Abschaltkriteriums herangezogen, sondern in Echtzeit einem übergeordneten Controllersystem zur Auswertung zur Verfügung gestellt wird.

Die Schutzschaltung basiert auf den Eigenschaften der eingesetzten Leistungsschalter, die durch ihre konstruktiv bedingten Schaltverluste, deren Durchlaßverluste und inneren thermischen Widerstände die Grundlage für die Dimensionierung eines Betriebskennfeldes bilden.

Beispielhaft sind Betriebsparameter wie Temperatur des Kühlkörpers, Taktfrequenz, Zwischenkreisspannung, zeitlicher Leitzustand von IGBT bzw. Freilaufdiode signifikante und meßbare Parameter. Sie sind für jeden Leistungsschalter bekannte und definierte Größen, die in den Grenzen des dynamischen Verhaltens im Einsatz variieren, bzw. konstant sind. Diese Betriebsparameter bilden beispielhaft das Kennfeld, das durch seine korrelative Bewertung zu den jeweils augenblicklich zulässigen Schwellwertergebnissen führt. Diese Schwellwerte begrenzen autark die maximal mögliche Belastung zu diesem Zeitpunkt.

Der Schutz des Leistungsteiles jeder Schaltungsanordnung kann durch die erfinderischen Maßnahmen über ein definiertes Kennfeld durch Bewertung der zu jeder Zeit vorhandenen Arbeitstemperatur und der Taktfrequenz des Systems erreicht werden. Unabhängig von äußeren Bedingungen wird die Einhaltung der vorgegebenen Grenzwerte und die Zulässigkeit jedes vom Controller angestrebten Zustandes überprüft.

Bei aktuellen Anlässen kann in gleicher Weise ein Eingrenzen des aktuell zulässigen Stromwertes erfolgen und damit eine Fahrweise mit verminderter Leistung oder veränderter Taktfrequenz gewählt werden, um durch eine momentane verminderte Stromtragfähigkeit als Ergebnis der Bewertung des Kennfeldes ein Abschalten der gesamten Schaltungsanordnung überflüssig zu machen oder zeitlich zu strecken.

In die Kennfeldbewertung können weitere Einflußgrößen des Arbeitsbereiches der Schaltungsanordnung aufgenommen werden, so ist es beispielhaft möglich, den aktuellen Stand der Zwischenkreisspannung zusätzlich zu berücksichtigen und eine Bewertung der Stromflußzeit ist erreichbar.

Zusammenfassend gilt die Aussage, daß auf der Grundlage eines installierten komplexen Kennfeldes eine dem aktuellen Zustand der Schaltungsunordnung adäquate Strombegrenzung möglich ist und es ist durch eine interne analoge Signalverarbeitung im Kennfeld eine sehr geringe Verzögerungszeit von kleiner als 1 ms möglich. Durch einen D/A- Wandler in Zusammenwirken mit einem Mikroprozessor oder Signalprozessor stehen die gewonnenen Kennfeldinformationen auch für digitale Schnittstellen zur Verfügung.

Nachfolgend werden die Erfindungsgedanken an Hand von skizzenhaften Darstellungen in den Figuren 1 bis 5 näher erläutert:
**Fig. 1** stellt den modernen Stand der Schaltungstechnik dar.
**Fig. 2** skizziert ein Beispiel für die Bestimmung von Durchlaßverlusten.
**Fig. 3** skizziert ein Beispiel für die Bestimmung von Schaltverlusten.
**Fig. 4** skizziert ein erfindungsgemäßes dreidimensionales Kennfeld mit zwei Eingangssignalen.
**Fig. 5** skizziert eine Teilschaltung zur erfinderischen Signalgewinnung.

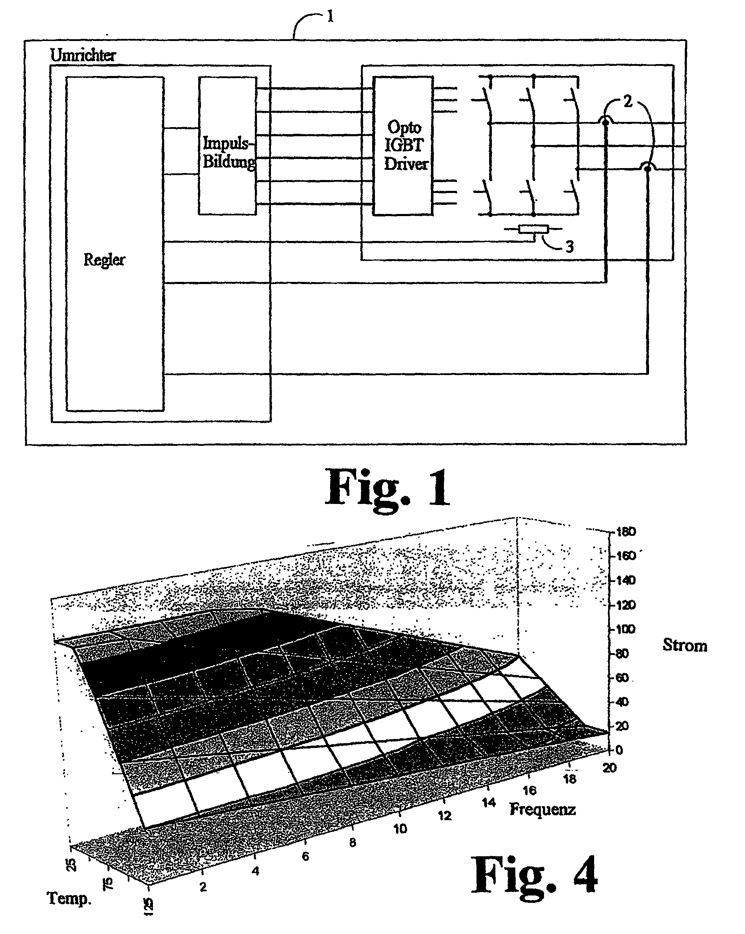

**Fig. 1** stellt den modernen Stand der Schaltungstechnik dar. In Umrichtern (1) werden die Ausgangsströme in der Regel mit Stromsensoren (2) erfaßt. Zum Schutz vor Überlastung wird der Augenblickswert des Stromsignals mit einem Schwellwert, der außerhalb des normalen Betriebsbereiches liegt, verglichen. Bei Überschreiten des Schwellwertes wird das Gesamtsystem, also die Schaltungsanordnung, abgeschaltet.

Die Festlegung der Schwellwerte erfolgt bei derartigen Systemen aufgrund thermischer Messungen während der Entwicklungs- und Erprobungsphase eines jeden neu erdachten Systems von Schaltungsanordnungen. In Erweiterung dieser Vorgehensweise werden für bestimmte Kühlkörpertemperaturen (3) Vorhersagen für erlaubte Belastungen fixiert, die Grundlage für die Schwellwerte aller nachträglich aufgebauten Anordnungen sind. Der nach Fig. 1 aufgezeigte Stand der Technik birgt in sich einige Nachteile. Bei Änderungen der Schaltungsanordnungen im Bereich des Leistungsteiles, beispielhaft bei Einsatz eines anderen Kühlkörpers, müssen die Schwellwerte durch erneute thermische Messungen neu definiert werden.

Die Schwellen sind statischer Natur, sie müssen immer wieder für jeden einzelnen Einflußfaktor bei jeder Änderung neu ermittelt und festgelegt werden. Jede dynamische Veränderung der Schaltungsanordnung, wie beispielhaft Unterspannungen am Lüftungssystem, Verschmutzung der Kühlprofile oder schwankende Umgebungstemperaturen bewirkt eine Änderung der Leistungsbereitschaft der Schaltungsanordnung und muß bei statischer Schwellwertbegrenzung als Reserve berücksichtigt werden. Die konstruktive Leistungsfähigkeit einer solchen Schaltungsanordnung kann nicht voll genutzt werden. In jedem Falle müssen die ungünstigsten Arbeitsbedingungen für die Grenzfallfestlegungen dienen, was erhebliche Leistungsabstriche bedeutet.

In Hei-7-255166 wird eine dem Stand der modernen Technik entsprechende Schaltung vorgestellt. Es wird ein thermischer Überlastschutz dargestellt, der die Leistungsbauelemte eines Umrichters bei niedriger Ausgangsfrequenz schützt. Hierzu wird die Zeit bestimmt, nach der die Grenztemperatur des Leistungsbauelementes bei gegebener Last überschritten würde. Vor Erreichen dieser Zeit wird der Umrichter abgeschaltet, wenn sich nichts an der Belastungssituation geändert hat.

EP 0 792 008 A2 beschreibt eine Methode und eine Vorrichtung für den thermischen Überlastschutz bei Umrichtern mit sinusförmigen Ausgangsgrößen, bei dem der Temperaturanstieg des Bauelementes ausgewertet wird, bei Überschreiten einer definierten Anstiegsgrenze wird das Tastverhältnis reduziert, um die thermische Überlastung des Leistungsbauelementes zu vermeiden.

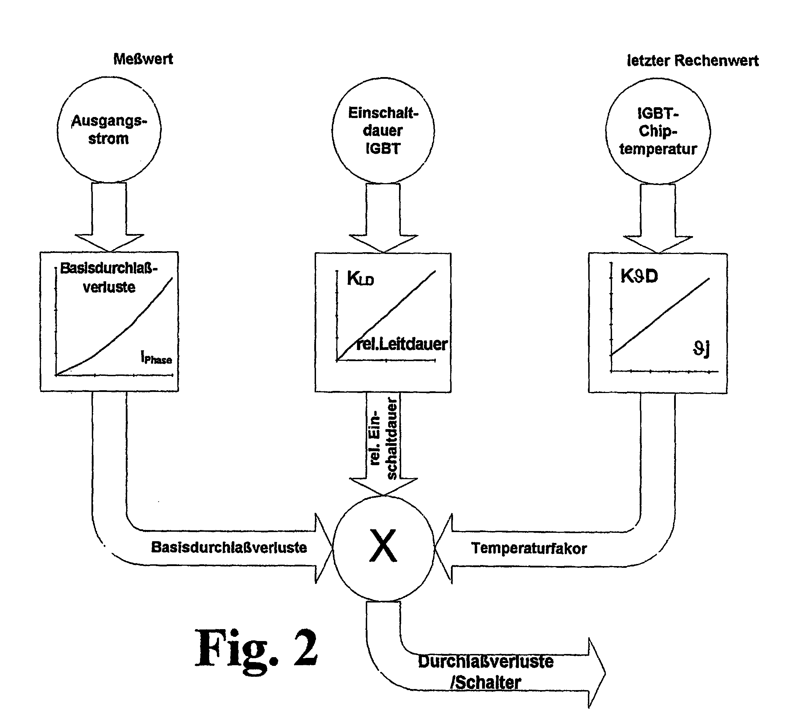

**Fig. 2** skizziert ein erfinderisches Beispiel für die Bestimmung von Durchlaßverlusten. Die Ermittlung der Leitverluste wird an einem Beispiel mit IGBT- Aufbauten aus den aktuellen Betriebsbedingungen erläutert. Wegen der Trägheit des Wärmetransportes ist es wichtig, die für den Überlastschutz erforderlichen Daten direkt an der Entstehungsstelle zu erheben, das ist Grundlage der erfinderischen Idee. Die Entstehungsstelle ist in den pn- Übergängen der Leistungstransistoren und -dioden zu finden, folglich müssen Meßwerte und Messungen unmittelbar an diesen Bauelementen erfolgen.

So werden in Abhängigkeit von dem Ausgangsstrom die "Basisdurchlaßverluste" als Kennwert für die eingesetzten Leistungsbauelemente für den Normbetrieb ermittelt und zur Bewertung herangezogen. Die Basisdurchlaßverluste werden durch die in Wärme umgewandelte elektrische Energie definiert, die in der Durchlaßphase des beispielhaft eingesetzten IGBT entstehen. Konstruktionsbedingt ist diese Verlustwärme funktionell von der Menge des transportierten Ausgangsstromes (Iₚₕₐₛₑ), der mit einem Stromsensor erfaßt wird, abhängig.

Die Einschaltdauer als "relative Leitdauer", die den Zeitraum des beispielhaft verwendeten IGBT einer Schaltperiode umfaßt, ist ein zweiter signifikanter Schaltparameter und Faktor für die Steuerung der zulässigen Belastbarkeit der Schaltungsanordnung. Für den Korrekturfaktor Leitdauer (K_{LD}) wird die aktuelle Leitdauer auf die Leitdauer des Bauelementes im Normbetrieb bezogen (rel. Leitdauer).

Die Erfassung und Bewertung der Chiptemperatur (ϑ_{J}) als aktuelle Sperrschichttemperatur des Halbleiterbauelementes ist für ein funktionstüchtiges Arbeiten des Überlastschutzes von entscheidender Bedeutung. Über einen "Korrekturfaktor Temperatur" (KϑD) wird aus der aktuellen Sperrschichttemperatur ein Faktor aus den stromabhängigen Basisdurchlaßverlusten gefunden. Einerseits erhöht sich primär die Chiptemperatur in Abhängigkeit von der Größe der erzeugten Verlustleistung. Andererseits kann die Chiptemperatur eines Chips auch passiv durch andere Bauelemente mit Verlustleistung dadurch erhöht werden, weil sie auf gleichen thermisch miteinander verbundenen Trägern positioniert sind.

Es wird ganz allgemein indirekt durch die Schaltunganordnung mit deren übrigen Schaltelementen und/oder durch den Kühlkörper Wärme ausgleichend auf alle Bauteile übertragen und damit jeder einzelne Chip eine passive Wärmebelastung erhalten, zumindest jedoch erfolgt eine Beeinflussung. So ist es denkbar, daß unter ungünstigen Bedingungen kaum eine Leistung von einem Leistungsschalter erwartet werden kann, wenn die passive Erwärmung durch dessen "Umfeld" bereits sehr hoch ist.

Als Startbedingung für die Sperrschichttemperatur wird die Kühlkörpertemperatur herangezogen, für die folgenden Bedingungen wird die jeweilige in der vorangegangenen Berechnung ermittelte Temperatur eingesetzt. Der Korrekturfaktor Temperatur (KϑD) wird über den Kennlinienzusammenhang zur Sperrschichttemperatur ermittelt.

Diese hier beispielhaft dargestellten drei Parameter werden als Faktoren miteinander als Produkt über die Multiplikationsstelle zur weiteren Verwertung als nutzbarer Faktor "Durchlaßverluste/Schalter" der digitalen Bewertungseinheit (z.B. µ- Controller) zugeführt.

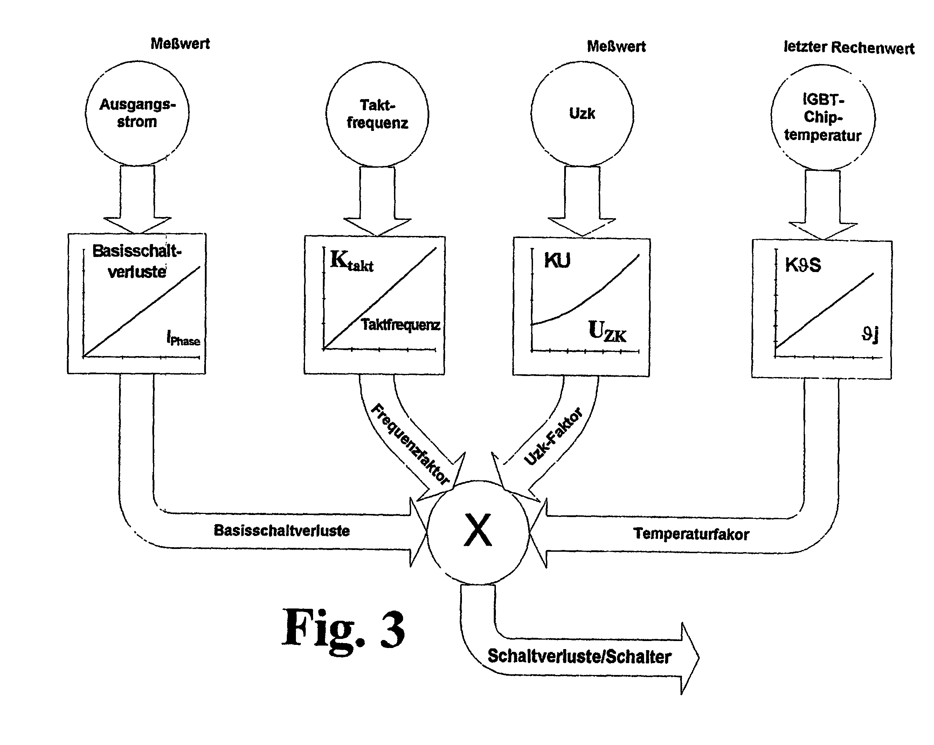

**Fig. 3** skizziert ein Beispiel für die Bestimmung von Schaltverlusten. Aus den aktuellen Betriebsbedingungen am Beispiel eines IGBT werden die Daten ermittelt. Es werden vier Faktoren dargestellt.

Aus dem Ausgangsstrom (Iₚₕₐₛₑ) werden Basisschaltverluste als Kennwert der eingesetzten Leistungshalbleiterbauelemente fiir einen Normbetrieb ermittelt, in Abhängigkeit von dem Phasenstrom ergibt sich der erste Faktor fiir die nachfolgende Bewertung.

Aus der Taktfrequenz und dem realisierten Arbeitstakt ergibt sich nach Bewertung über einen Korrekturfaktor (Ktakt) der Frequenzfaktor. In gleicher Weise ergibt sich nach Bewertung über einen Korrekturfaktor (KU) der Faktor der Zwischenkreisspannung auf (Uzk). In analoger Weise zu Fig. 2 wird der vierte Rechenwert, die Chiptemperatur (ϑ_{J}), gebildet, hier jedoch mit den Schaltverlusten verknüpft. Es ergibt sich auch hier ein Temperaturfaktor. Der Korrekturfaktor Temperatur (KϑS) wird aus der aktuellen Sperrschichttemperatur für die stromunabhängigen Basisverluste ermittelt.

Das Produkt der Multiplikationsstelle (X) in Fig. 3 bildet als Ergebnis die "Schaltverluste/Schalter" als zweiten beispielhaft errechneten Wert. Die aktuellen Schaltverluste des Halbleiterbauelementes werden widergespiegelt.

Die Summe aus Schaltverlusten und Leitverlusten pro Chip (IGBT und Freilaufdiode) stellen die Gesamtbelastung der jeweiligen Halbleiterchips dar, diese werden einem thermischen Modell der Halbleiteranordnung zugeführt und daraus wird die aktuelle Chiptemperatur (ϑ_{J}) ermittelt.

Aus der Differenz der aktuellen Chiptemperatur (ϑ_{J}) zur Chip- Grenztemperatur kann der aktuelle gerade noch mögliche Ausgangsstrom und damit der Grad der aktuellen Auslastbarkeit des Systems bestimmt werden, bzw. es kann die zur Verfügung stehende Reserve zur Grenze bekanntgegeben werden. Die überlagerte Steuerung kann damit Auslastungstendenzen bestimmen und so im Vorfeld reagieren.

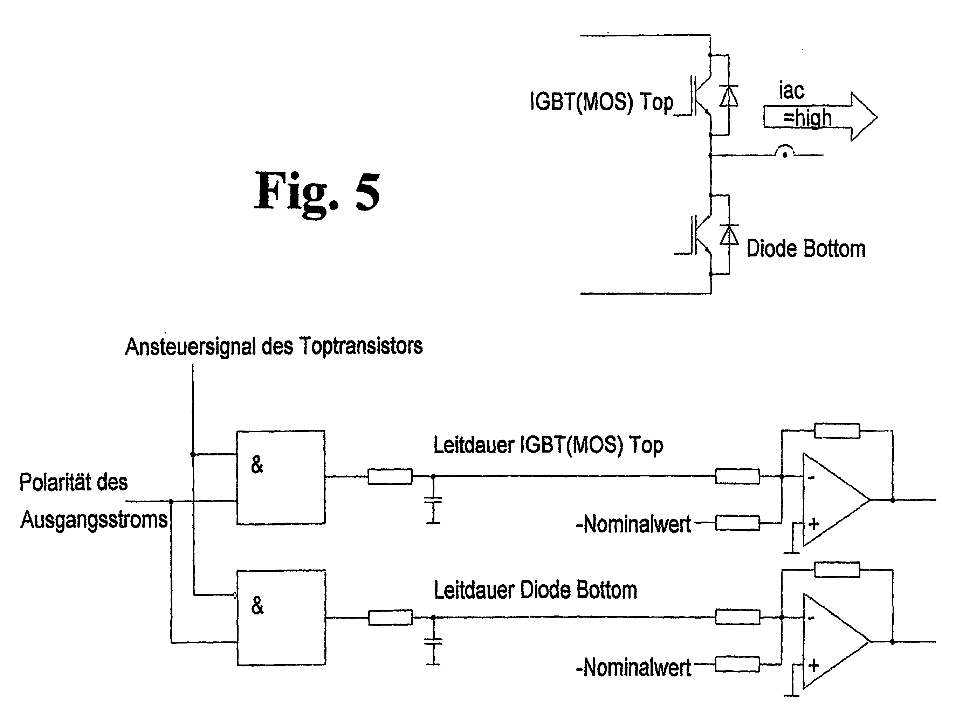

**Fig. 4** skizziert ein erfindungsgemäßes dreidimensionales Kennfeld mit zwei Eingangssignalen, der Temperatur und der Arbeitsfrequenz. Die komplexe Wirkung von nur zwei Variablen zeigt die enormen Auswirkungen auf die Strombelastbarkeit. Bereits bei sehr guter Kühlung, also Temperaturen unter 50°C sinkt die Belastbarkeit bei 20 kHz auf etwa die Hälfte, bei nicht ausreichender Kühlleistung reduziert sich diese jedoch auf ein Viertel des eben genannten Wertes.

In einem praktischen Fall wird jedoch ein vielfaches von Variablen wirksam, das gesamte Kennfeld aller Einflußfaktoren wirkt im Komplex parallel und beeinflusst in Abhängigkeit von dem momentanen Laststrom unterschiedlich stark letztlich die Chiptemperatur (ϑ_{J}) der Leistungsschalter und der Freilaufdioden. Bei Vorgabe einer maximal zulässigen Temperatur für alle Verlustleistung bringenden Bauteile der Schaltungsanordnung ergibt sich, je nach Arbeitsbereich ein unterschiedlicher gerade noch praktisch möglicher Temperaturanstieg für jeden arbeitenden Halbleiterkörper. Das bedeutet, daß sich die gerade noch zulässige Strombelastbarkeit dynamisch entsprechend verändern muß.

Diese hier aufgezeigte dynamische Schwelle ist Zielpunkt der Erfindung. Wird die Schwelle nämlich selbstadaptierend gestaltet, dann kann einerseits ohne Zerstörung der Schaltungsanordnung eine Überlastabschaltung erfolgen, es kann aber ansteuertechnisch abhängig von der dynamischen Schwelle eine reduzierte Leistung eingeprägt werden und parallel kann eine Fehlermeldung erfolgen.

Die vorliegende Erfindung geht nicht von sinusförmigen Stromverläufen, dem dazugehörenden Leistungsfaktor und dessen Anpassung aus, sondern von der aktuellen Leitdauer jedes einzelnen Bauelementes. Damit stellt diese Erfindung ein applikationsunabhängiges Schutzkonzept vor, das für alle hart schaltenden Systeme und damit neben anderen auch für Synchronmotoren, bürstenlose Gleichstrommotoren, Netzteile und Schweißgeräte einsetzbar ist. Die Zuordnung der Schutzeinrichtung zum Leistungsteil im einfachsten Fall zu einem Schalter mit Freilaufdiode, zu einer Halbbrücke oder einer H- Brücke ist die Grundlage fiir diese Unabhängigkeit.

Zu den beschriebenen Betriebsgrößen wird die Temperaturabhängigkeit der Bauelemente weitestgehend berücksichtigt, wie auch der Einfluß der Zwischenkreisspannung. Die Kühlkörpertemperatur wird als Basisgröße für die Berechnung der aktuellen Chiptemperatur (ϑ_{J}) erfaßt. Aus vorgenannten aktuellen Daten wird die aktuelle Auslastung bestimmt und als Information dem überlagerten System zur Verfügung gestellt. Durch Last- oder Frequenzreduktion kann die aktuelle thermische Belastung reduziert und damit ein Abschalten durch Überschreiten der Temperaturgrenzen vermieden werden.

**Fig. 5** skizziert eine Teilschaltung zur erfinderischen Signalgewinnung. Die Ermittlung der Bauelemente- Leitdauer wird am Beispiel eines Schaltungsausschnittes einer erfinderischen Schaltungsanordnung erläutert. Dargestellt ist der Kommutierungskreis eines IGBT in TOP-Position und einer Freilaufdiode in Bottom- Position einer Halbbrücke. Der aus diesem Schaltungsast herausfließende positive Ausgangsstrom entspricht einem HIGH- Signal, wenn das Ansteuersignal HIGH - Pegel aufweist, dann wird der IGBT angesteuert.

In diesem Schaltungszustand kann entweder die Bottom- Freilaufdiode oder der TOP-Transistor leitend sein. Damit ist die Polarität des Ausgangsstromes (iac) bestimmend für die Auswahl von TOP- Transistor und Bottom- Freilaufdiode als aktuell aktive Bauelemente. Wenn bei positivem Ausgangsstrom gleichzeitig der TOP- Transistor angesteuert wird, dann fließt der Strom durch den Transistor, die Freilaufdiode ist ausgeschaltet.

Die &- Verknüpfung von Strompolarität und TOP- Transistoransteuersignal hat am Ausgang ein HIGH - Signal, wenn der Strom positiv ist und der TOP- Transistor angesteuert wird, dann ist dieses Signal kennzeichnend fiir den "EIN- Zustand" des TOP- Transistors. Verglichen mit einem normierten Signal ergibt sich eine Information über eine relative Einschaltdauer des TOP- Transistors.

Die &- Verknüpfung von Strompolarität und invertiertem TOP- Transistoransteuersignal hat am Ausgang ein HIGH - Signal, wenn der Strom positiv ist und der TOP- Transistor angesteuert wird, dann ist dieses Signal kennzeichnend für den "EIN- Zustand" der Freilaufdiode Bottom. Verglichen mit einem normierten Signal ergibt sich eine Information über eine relative Einschaltdauer der Freilaufdiode Bottom.

Mit einer Online- Temperaturerfassung kann das Leistungsteil vollständig gegen thermische Überlastung geschützt werden. Zur Berechnung der Verluste sind umfangreiche Rechenoperationen notwendig, die mit Analogschaltungen nicht wirtschaftlich zu realisieren sind. Auch ein low-cost- µController als Lösung für die erfinderische Idee ist hier erfolgreich einsetzbar.

Mit solch einer Lösung können weitere Funktionen realisiert werden. Ein elektronisches Typenschild ist erstellbar. Ein digitaler Datenaustausch mit einem Regler ist möglich, dadurch sind detaillierte Fehlermeldungen statt Summenfehlerbenennung mit einer digitalen Istwert-Ausgabe möglich. Aktuelle Istzeit- Werte für Temperaturen der Chips und Kühlkörper sowie daraus resultierende Stromgrenzen sind verfügbar.

## Patentansprüche

1. Schaltungsanordnung mit Überlastbewertung der Leistungshalbleiterbauelemente, insbesondere MOSFET- oder IGBT- Schalter mit parallel geschalteten Freilaufdioden,
**dadurch gekennzeichnet, daß**
mindestens zwei direkt meßbare Betriebsparameter der Leistungshalbleiterbauelemente und / oder des Gesamtsystems kontinuierlich gemessen werden, jeder dieser Parameter auf eine Basisgröße normiert wird, diese in einer Multiplikationsstelle mit mindestens einem weiteren errechnetem Parameter zu einem Kennfeld kombiniert werden, die Daten dieses Kennfeldes durch eine analoge Signalverarbeitung kontinuierlich bewertet werden, im Falle einer aus dieser Bewertung ersichtlichen bevorstehenden oder bereits bestehenden Überlastung die Parameter der Ansteuerung der Schaltungsanordnung verändert werden, um ein Abschalten der gesamten Schaltungsanordnung überflussig zu machen oder zeitlich zu strecken, sowie das Ergebnis der Bewertung an ein übergeordnetes Regelsystem gemeldet wird.

2. Schaltungsanordnung nach Anspruch 1., **dadurch gekennzeichnet, daß**
als Betriebsparameter
- die Temperaturen der pn- Übergänge (ϑ_{J}) der in der Schaltungsanordnung eingesetzten Leistungshalbleiterbauelemente, wie IGBT oder MOSFET und Freilaufdioden,
- die Temperatur(en) der Kühleinrichtung(en),
- Taktfrequenzen,
- Zwischenkreisspannungen,
- Ausgangsstrom und dessen Polarität,
- Einschaltdauer herangezogen werden.

3. Schaltungsanordnung nach Anspruch 1, **dadurch gekennzeichnet, daß**
auf der Grundlage einer Temperatursimulation und aus den Betriebs- und den Grenzdaten eine Stromabschaltschwelle errechnet wird.

4. Schaltungsanordnung nach Anspruch 2, **dadurch gekennzeichnet, daß**
die Betriebsparameter als Basisdaten digitalisiert und die Verarbeitung der Daten über eine digitale Signalverarbeitung realisiert werden.

5. Schaltungsanordnung nach Anspruch 4, **dadurch gekennzeichnet, daß**
die Betriebsparameter über digitale Schnittstellen fiir eine aktuelle und individuelle Bewertung des Betriebes der gesamten Schaltungsanordnung und dessen aktuelle Auslastungsgrenzen mit den verfügbaren Leistungsreserven zur Verfügung steht.

## Claims

1. Switching arrangement with overload evaluation of the power semiconductor components, in particular MOSFET or IGBT switches with parallel-connected freewheel diodes,
**characterized in that**
at least two directly measurable operating parameters of the power semiconductor components and/or of the whole system are continuously measured, each of these parameters are normalized to a basic quantity, said parameters are combined in a multiplication means with at least one further, computed parameter to form a characteristic field, the data of said characteristic field are continuously evaluated by means of an analogue signal-processing means, in the case of an overload which is to occur and which is apparent from this evaluation, or an already existing overload, the control parameters of the switching arrangement are modified in order to avoid the necessity of switching off the whole switching arrangement, or to temporally extend such switching-off, and the result of the evaluation is reported to a superordinate control system.

2. Switching arrangement according to Claim 1,
**characterized in that** the following are used as operating parameters:
- the temperature of the pn junctions (θj) of the power semiconductor components, e.g. IGBTs or MOSFETs. and freewheel diodes, employed in the switching arrangement,
- the temperature(s) of the cooling means,
- clocking frequencies,
- intermediate-circuit voltages,
- output current and polarity thereof,
- switch-on duration.

3. Switching arrangement according to Claim 1,
**characterized in that** a current switch-off threshold is computed on the basis of a temperature simulation and from the operating data and limit data.

4. Switching arrangement according to Claim 2,
**characterized in that** the operating parameters are digitized as basic data and the data are processed via a digital signal-processing means.

5. Switching arrangement according to Claim 4,
**characterized in that** the operating parameters are available via digital interfaces for an up-to-date and individual evaluation of the operation of the whole switching arrangement and of its present loading limits with the available power reserves.

## Revendications

1. Dispositif de circuit avec évaluation de surcharge des composants semi-conducteurs de puissance, notamment des MOSFET ou des IGBT à diodes de roue libre couplées en parallèle, **caractérisé en ce qu'**au moins deux paramètres de fonctionnement directement mesurables des composants semi-conducteurs de puissance et/ou de l'ensemble du système sont mesurés en permanence, chacun de ces paramètres étant normalisé sur une grandeur de base, ceux-ci étant combinés dans un point de multiplication avec au moins un autre paramètre calculable pour constituer un champ caractéristique, les données de ce champ caractéristique sont évaluées en permanence par un traitement de signaux analogiques, les paramètres d'excitation du dispositif de circuit étant modifiés en cas de surcharge prévisible suite à cette évaluation ou déjà présente, pour rendre superflu ou étaler dans le temps une coupure de l'ensemble du dispositif de circuit, le résultat de l'évaluation étant signalé à un système régulateur hiérarchiquement supérieur.

2. Dispositif de circuit selon la revendication 1, **caractérisé en ce qu'**en tant que paramètres de fonctionnement sont pris en compte
- les températures des jonctions PN (ϑⱼ) des composants semi-conducteurs de puissance utilisés dans le dispositif de circuit tels que des IGBT ou des MOSFET et des diodes de roue libre,
- la (les) température(s) du (des) dispositif(s) de refroidissement,
- les cadences d'horloge,
- les tensions de circuit intermédiaire,
- le courant de sortie et sa polarité,
- le temps de fonctionnement.

3. Dispositif de circuit selon la revendication 1, **caractérisé en ce que** l'on calcule un seuil de coupure de courant sur la base d'une simulation de température et à partir des données de fonctionnement et des données limites.

4. Dispositif de circuit selon la revendication 2, **caractérisé en ce que** les paramètres de fonctionnement sont numérisés sous la forme de données de base, et **en ce que** le traitement des données est réalisé à l'aide d'un traitement de signaux numériques.

5. Dispositif de circuit selon la revendication 4, **caractérisé en ce que** les paramètres de fonctionnement sont disponibles par l'intermédiaire d'interfaces numériques pour une évaluation actuelle et individuelle du fonctionnement de l'ensemble du dispositif de circuit et de ses limites actuelles de saturation avec les réserves de puissance disponibles.
